# EUROPEAN PATENT APPLICATION

(11) **EP 0 782 264 A2**
(43) Date of publication of application: **02.07.1997**
(21) Application number: 96119958.5
(22) Date of filing: 12.12.1996
(51) Int. Cl.: H03K 5/08

(54) **Digital receiver with adaptive threshold valves**

(30) Priority: 26.12.1995 US 578728
(71) Applicant: MOTOROLA, INC., Schaumburg, IL 60196 (US)
(72) Inventor: Chun, Christopher K.Y., Giolbert, Arizona 85233 (US); Shook, Stephen G., Gilbert, Arizona 85233 (US); Schwartz, Daniel B., Apache Junction, Arizona 85219 (US)
(74) Representative: Hudson, Peter David

(57) **Abstract**

A digital signal processing circuit (10) stores the peak value of the input signal on a storage element (26). The stored peak value is converted to a digital value (33). A ratio circuit forms a percentage value (36) that is a percent of the digital value (33). The percentage value (36) digitally stored and is used to form the threshold voltage (39). The threshold voltage (39) is compared to the input signal to produce an output (23).

## Description

### Background of the Invention

The present invention relates, in general, to communication systems, and more particularly, to signal processing circuits for communication systems.

In the past, a variety of design approaches have been utilized to implement signal processing circuits for communication systems, such as receivers for optical communication systems. Several methods are used for receiver designs in such systems including differential, adaptive feedback, fixed threshold, and edge detection methods.

One problem with the adaptive feedback receivers is the operation during idle time of the burst-mode communication signal applied to the receiver. Such circuits typically utilize differential amplifiers and have feedback loops in order to implement automatic gain control and automatic offset control within the receivers. During idle time, the feedback loop decreases threshold voltage applied to the differential amplifiers thereby causing the receiver to output noise. Additionally, the peak and minimum input voltage values drift over time causing pulse width distortion or even erroneous signals in the output from the receivers.

Fixed threshold schemes typically require a large dynamic range which results in pulse width distortion. Differential and edge detection schemes are edge rate dependent and also result in pulse width distortion.

Accordingly, it is desirable to have a signal processing circuit that does not oscillate, that does not utilize feedback, and that minimizes pulse width distortion in the output signal.

### Brief Description of the Drawings

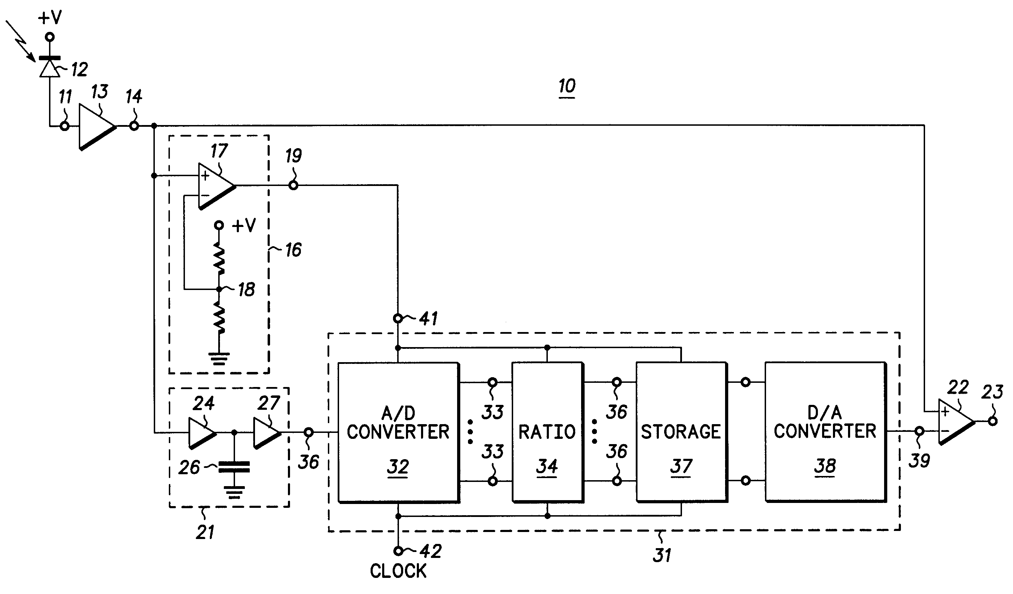

The Sole FIGURE schematically illustrates a digital signal processing circuit in accordance with the present invention.

### Detailed Description of the Drawings

The sole FIGURE schematically illustrates a digital signal processing circuit 10 suitable for receiving burst-mode signals, and that minimizes pulse-width distortion. Circuit 10 includes a received data input 11 suitable for accepting a received signal, such as the signal from a photodetector 12 that detects light received by a fiber optic communication system. The received signal on input 11 is applied to an input of a preamplifier 13 which amplifies the received signal to form an input signal on an output of preamplifier 13. The input signal is applied to a signal input 14 of circuit 10. Circuit 10 includes an activity detector 16, a peak hold circuit 21, a digital threshold circuit 31, and a comparator 22. Activity detector 16 is used for detecting the reception of an input signal on input 14. Detector 16 has an output 19 that provides an activity signal which remains inactive or low when a signal is not detected on input 14. That is, when the input signal does not have transitions, for example during idle time between signal bursts of burst-mode communication signals. Output 19 is active when the input signal has transitions. The activity signal on output 19 is connected to an enable input 41 of circuit 31 and is used to inhibit the operation of circuit 31 when an input signal is not detected. Typically, detector 16 includes a threshold setting circuit that compared to the input signal via a comparator. In one embodiment, the threshold setting circuit is a resistive voltage divider that provides a threshold voltage at a node 18. The threshold voltage is applied to a negative input of a comparator 17 in order to provide a reference voltage. The input signal on input 14 is connected to a positive input of comparator 17 in order to determine if transitions are occurring on the input signal. Detector 16 can have other embodiments that also detect the presence of a signal on input 14.

Peak hold circuit 21 is used for determining and storing the peak value of the input signal applied to input 14. Circuit 21 has an output 28 that provides a stored peak value of the input signal. The stored peak value is received by circuit 31. Typically, circuit 21 includes a peak detection circuit 24 that receives the input signal on input 14 and stores the peak value of the input signal on a storage element 26 in order to form the stored peak value. A buffer 27 buffers the storage element from other portions of circuit 10 to prevent changing the stored peak value. An example of such a peak value detection and storage circuit is provided in a reference by Makoto Nakamura et. al., "An Instantaneous Response CMOS Optical Receiver IC With Wide Dynamic Range and Extremely High Sensitivity Using Feed-Forward Auto-Bias Adjustment", IEEE Journal of Solid-State Circuits, Vol. 30, No. 9, Sept. 1995.

Digital threshold circuit 31 digitally forms a threshold voltage from the peak value of the input signal, and digitally stores the threshold voltage. The threshold voltage is provided on an output 39 and is used for biasing comparator 22. As will be seen hereinafter, the threshold voltage is formed after detector 16 determines the reception of an input signal. Circuit 31 receives the stored peak value of the input signal on output 28 as an analog signal. Circuit 31 utilizes an analog-to-digital converter 32 to convert the analog stored peak value to a digital word representing a digital value of the analog stored peak value. The digital word or digital value is presented on outputs 33 of converter 32. A ratio circuit 34 receives the digital value and decreases the digital value by a percentage amount to form a percentage value on outputs 36 of circuit 34. That is, ratio circuit 34 decreases the digital value received from converter 32 to an amount that is a percent of the digital value. This percentage value represents the switching point of the input waveform that will be used by comparator 22. Typically, fifty percent is utilized as the percentage amount so that the percentage value on outputs 36 is approximately fifty percent of the digital value on outputs 33.

Ratio circuit 34 can have a variety of embodiments depending upon the sophistication desired in developing the percentage value. In the preferred embodiment, ratio circuit 34 is a shift register or divide-by-two circuit. In another embodiment, circuit 34 can be a digital signal processing system that stores a history of ratio values and analyzes data to determine the ratio value based on previous variations of the input signal.

A digital storage element 37 is utilized to store the percentage value so that the stored percentage value remains constant until another input signal is detected by detector 16. The stored percentage value is received by a digital-to-analog converter 38 which converts the digital stored percentage value to an analog threshold voltage on output 39 of circuit 31. Since the stored percentage value is stored as a digital word and is used to generate the threshold voltage, the threshold voltage does not droop or decrease over time if there is a long period between input signals.

Converter 32, ratio circuit 34, and digital storage element 37 are inhibited from operating when enable input 41 is inactive, thus, circuit 31 is inhibited from digitally storing the percentage value prior to detector 16 detecting the reception of an input signal. A clock input 42 is utilized to provide timing sequences for the operation of converter 32, circuit 34, and element 37.

Comparator 22 receives the threshold voltage on a negative input and compares the input signal to the stored percentage value by utilizing the threshold voltage. Thus, comparator 22 substantially reproduces the input signal on output 23 of circuit 10.

By now it should be appreciated that there has been provided a novel digital signal processing circuit. Determining and storing the peak value of the input signal facilitates utilizing the peak value to determine the threshold voltage of the circuit. Storing the analog peak value of the input signal assists in ensuring that degradations in the input signal are tracked and do not result in pulse width distortion or false outputs. Converting the analog peak stored value to a digital value and forming a digital percentage value from the digital value facilitates storing the threshold voltage as a digital value. This assists in ensuring that the threshold voltage does not droop or drift over time. Changing the digital stored percentage value only when an input signal is present assists in ensuring that the threshold voltage does not change in response to noise in the input signal.

## Claims

1. A digital signal processing method (10) comprising:
determining (16) reception of an input signal (14);
digitally forming (34) a threshold voltage from the input signal after determining reception of the input signal (14); and
storing (37) a digital value representing the threshold voltage.

2. The method of claim 1 wherein digitally forming (32, 34) the threshold voltage from the input signal (14) includes digitally determining the threshold voltage as a percentage value of the input signal (14).

3. The method of claim 2 wherein digitally determining (34) the threshold voltage as the percentage value of the input signal (14) includes digitally determining a value of approximately fifty percent of the input signal (14).

4. The method of claim 2 wherein digitally determining (34) the percentage value of the input signal (14) includes converting a peak value of the input signal to a digital value, and decreasing the digital value to form the percentage value.

5. The method of claim 1 further including inhibiting (41) the steps of digitally forming (32, 34) the threshold voltage and storing (37) the digital value when the input signal is not detected.

6. The method of claim 1 wherein determining (16) reception of the input signal includes receiving the input signal (14), detecting (21) a peak value of the input signal (14), and storing the peak value (26).

7. A digital signal processing method (10) comprising:
detecting (16) reception of an input signal (14);
determining (21) a peak value of the input signal (14);
storing (21) the peak value on a storage element (26) to form a stored peak value;
digitally determining (32, 34) a percentage value of the stored peak value;
digitally storing (37) the percentage value to form a stored percentage value; and
comparing (22) the input signal (14) to the stored percentage value.

8. The method of claim 7 wherein digitally determining (32, 34) the percentage value of the stored peak value includes converting (32) the stored peak value to a digital value, decreasing (34) the digital value to form the percentage value, and digitally storing (37) the percentage value to form the stored percentage value.

9. The method of claim 8 wherein detecting (16) reception of the input signal (14) includes inhibiting (41) the step of digitally storing (37) the percentage value to form the stored percentage value prior to detecting reception of the input signal.

10. The method of claim 8 wherein detecting (16) reception of the input signal (14) includes inhibiting (41) the step of digitally determining (32, 34) the percentage value prior to detecting (16) reception of the input signal (14).
